# EUROPEAN PATENT APPLICATION

(11) **EP 4 773 759 A1**
(43) Date of publication of application: **08.07.2026**
(21) Application number: 25158014.8
(22) Date of filing: 14.02.2025
(51) Int. Cl.: H10F 39/00

(54) **IMAGE CAPTURING MODULE AND PORTABLE ELECTRONIC DEVICE**

(30) Priority: 02.01.2025 TW 114100036
(71) Applicant: Azurewave Technologies, Inc., 231 New Taipei City (TW)
(72) Inventor: YEH, Kuan-Hung, New Taipei City (TW); LIN, Mei-Ling, New Taipei City (TW); LIN, Ying-Liang, New Taipei City (TW)
(74) Representative: Viering, Jentschura & Partner mbB Patent- und Rechtsanwälte

(57) **Abstract**

An image capturing module (M) and a portable electronic device (P). The image capturing module (M) includes a circuit substrate (1), an image sensing chip (2) and an insulating connection structure (3). The image sensing chip (2) is disposed in the through opening (1003) of the circuit substrate (1) and electrically connected to the circuit substrate (1). The insulating connection structure (3) is disposed in the through opening (1003) of the circuit substrate (1) and connected between the image sensing chip (2) and the circuit substrate (1). A lower surface (2002) of the image sensing chip (2) is not covered by the insulating connection structure (3) and is exposed outside. The circuit substrate (1) has a flat surrounding structure (11) adjacent to and surrounding the through opening (1003), and a lower surface (1110) of the flat surrounding structure (11) is flush with the lower surface (2002) of the image sensing chip (2), so that the insulating connection structure (3) will not overflow between the temporary carrier substrate and the flat surrounding structure (11).

## Description

### FIELD OF THE INVENTION

The present invention relates to an image sensor, and more particularly to an image capturing module configured for capturing images and a portable electronic device configured to use the image capturing module.

### BACKGROUND OF THE INVENTION

In the related art, an image sensing chip of an image capturing module can be disposed on the top of a circuit substrate without openings by wire bonding, or the image sensing chip of the image capturing module can also be disposed on the bottom of the circuit substrate with an opening by flip-chip bonding. However, the prior image capturing module still has room for improvement.

### SUMMARY OF THE INVENTION

In response to the above-referenced technical inadequacy, the present invention provides an image capturing module configured for capturing images and a portable electronic device configured to use the image capturing module.

In order to solve the above-mentioned problems, one of the technical aspects adopted by the present invention is to provide an image capturing module, which includes a circuit substrate, an image sensing chip and an insulating connection structure. The circuit substrate has an upper surface, a lower surface, and a through opening connected between the upper surface and the lower surface. The image sensing chip is disposed in the through opening of the circuit substrate and electrically connected to the circuit substrate. The insulating connection structure is disposed in the through opening of the circuit substrate and connected between the image sensing chip and the circuit substrate. A lower surface of the image sensing chip is not covered by the insulating connection structure and is exposed outside. The circuit substrate has a flat surrounding structure adjacent to and surrounding the through opening, and a lower surface of the flat surrounding structure is flush with the lower surface of the image sensing chip.

In order to solve the above-mentioned problems, another one of the technical aspects adopted by the present invention is to provide a portable electronic device configured to use an image capturing module. The image capturing module includes a circuit substrate, an image sensing chip and an insulating connection structure. The circuit substrate has an upper surface, a lower surface, and a through opening connected between the upper surface and the lower surface. The image sensing chip is disposed in the through opening of the circuit substrate and electrically connected to the circuit substrate. The insulating connection structure is disposed in the through opening of the circuit substrate and connected between the image sensing chip and the circuit substrate. A lower surface of the image sensing chip is not covered by the insulating connection structure and is exposed outside. The circuit substrate has a flat surrounding structure adjacent to and surrounding the through opening, and a lower surface of the flat surrounding structure is flush with the lower surface of the image sensing chip.

Therefore, in the image capturing module and the portable electronic device provided by the present invention, by virtue of "the image sensing chip being disposed in the through opening of the circuit substrate and electrically connected to the circuit substrate," "the insulating connection structure being disposed in the through opening of the circuit substrate and connected between the image sensing chip and the circuit substrate," "a lower surface of the image sensing chip being not covered by the insulating connection structure and being exposed outside" and "the circuit substrate having a flat surrounding structure adjacent to and surrounding the through opening," a lower surface of the flat surrounding structure can be substantially (or completely) flush with the lower surface of the image sensing chip.

These and other aspects of the present invention will become apparent from the following description of the embodiment taken in conjunction with the following drawings and their captions, although variations and modifications therein may be affected without departing from the spirit and scope of the novel concepts of the invention.

### BRIEF DESCRIPTION OF THE DRAWINGS

The described embodiments may be better understood by reference to the following description and the accompanying drawings, in which:
FIG. 1 is a schematic cross-sectional view of an image capturing module provided by a first embodiment of the present invention (before removing a temporary carrier substrate);
FIG. 2 is a schematic cross-sectional view of the cooperation between the flat surrounding structure and the insulating covering layer provided in the first embodiment of the present invention or a schematic cross-sectional view taken along line II-II of FIG. 1 (before removing the temporary carrier substrate);
FIG. 3 is a schematic cross-sectional view of the image capturing module provided by the first embodiment of the present invention (after removing the temporary carrier substrate);
FIG. 4 is a schematic cross-sectional view of the cooperation between the flat surrounding structure and the insulating covering layer provided in the first embodiment of the present invention or a schematic cross-sectional view taken along line IV-IV of FIG. 3 (after removing the temporary carrier substrate);
FIG. 5 is a schematic cross-sectional view of the image capturing module provided by a second embodiment of the present invention (before removing the temporary carrier substrate);
FIG. 6 is a schematic cross-sectional view of the cooperation between the flat surrounding structure and the insulating covering layer provided in the second embodiment of the present invention or a schematic cross-sectional view taken along line VI-VI of FIG. 5 (before removing the temporary carrier substrate);
FIG. 7 is a schematic cross-sectional view of the image capturing module provided by the second embodiment of the present invention (after removing the temporary carrier substrate);
FIG. 8 is a schematic cross-sectional view of the cooperation between the flat surrounding structure and the insulating covering layer provided in the second embodiment of the present invention or a schematic cross-sectional view taken along line VIII-VIII of FIG. 7 (after removing the temporary carrier substrate);
FIG. 9 is a schematic cross-sectional view of the image capturing module provided by a third embodiment of the present invention (before filling the insulating connection structure);
FIG. 10 is a schematic cross-sectional view of the image capturing module provided by the third embodiment of the present invention (after filling the insulating connection structure);
FIG. 11 is a schematic bottom view of a circuit substrate of the image capturing module provided by a fourth embodiment of the present invention;
FIG. 12 is a schematic cross-sectional view of the image capturing module provided by the fourth embodiment of the present invention (before filling the insulating connection structure);
FIG. 13 is a schematic cross-sectional view of the image capturing module provided by the fourth embodiment of the present invention (after filling the insulating connection structure); and
FIG. 14 is a functional block diagram of a portable electronic device using the image capturing module provided by a fifth embodiment of the present invention.

### DETAILED DESCRIPTION OF THE EXEMPLARY EMBODIMENTS

The present invention is more particularly described in the following embodiments and examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" may include plural reference, and the meaning of "in" may include "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

### [First Embodiment]

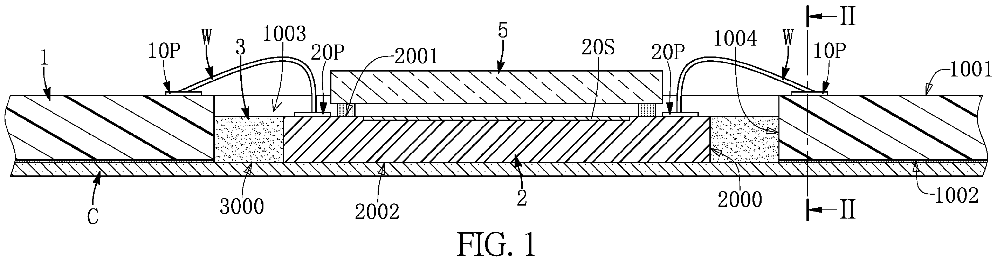

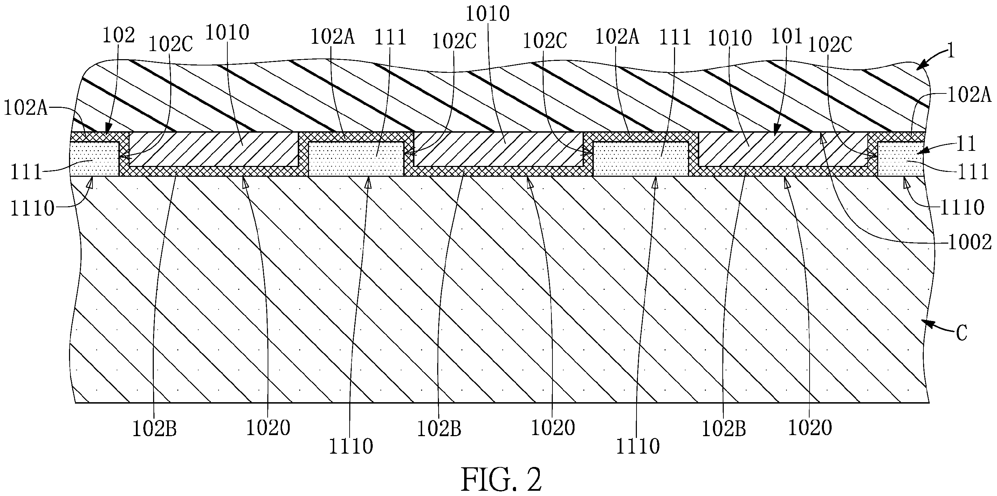

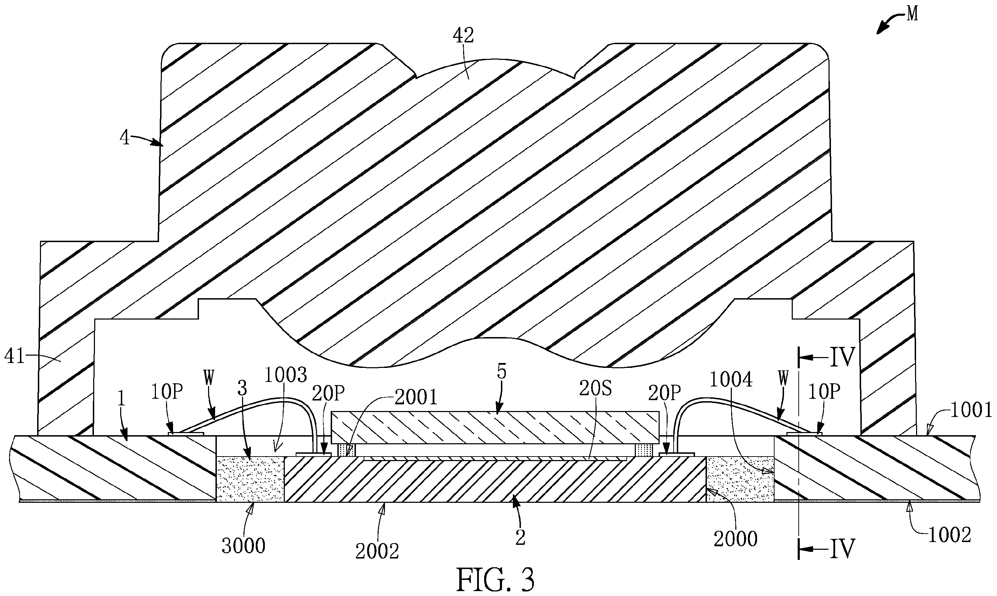

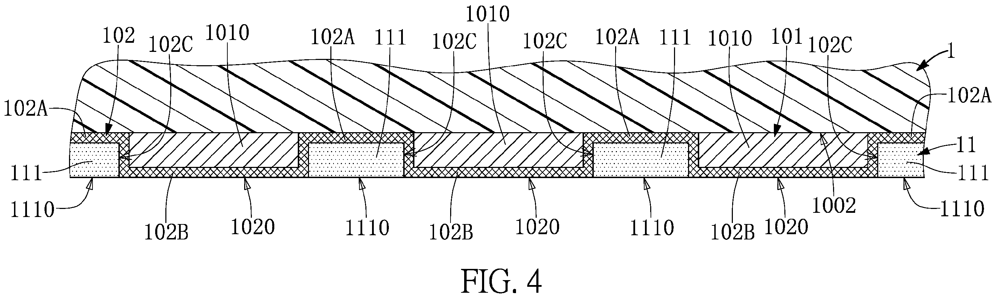

Referring to FIG. 1 to FIG. 4, a first embodiment of the present invention provides an image capturing module M (or an image sensing module), which may include a circuit substrate 1, an image sensing chip 2, an insulating connection structure 3 and a lens assembly 4. It should be noted that, FIG. 1 is a front cross-sectional schematic diagram of the image capturing module provided by the first embodiment of the present invention (before removing a temporary carrier substrate), and FIG. 2 is a partial side cross-sectional schematic diagram of FIG. 1. In addition, FIG. 3 is a front cross-sectional schematic diagram of the image capturing module provided in the first embodiment of the present invention (after removing the temporary carrier substrate), and FIG. 4 is a partial side cross-sectional schematic diagram of FIG. 3.

More particularly, referring to FIG. 1, FIG. 2 and FIG. 3, the circuit substrate 1 has an upper surface 1001, a lower surface 1002, and a through opening 1003 connected between the upper surface 1001 and the lower surface 1002 (or a through opening 1003 penetrating the circuit substrate 1), and the image sensing chip 2 can be disposed in the through opening 1003 of the circuit substrate 1 and electrically connected to the circuit substrate 1. In addition, the insulating connection structure 3 can be disposed in the through opening 1003 of the circuit substrate 1 and connected between the image sensing chip 2 and the circuit substrate 1, and the lens assembly 4 may include a lens holder 41 disposed on the circuit substrate 1 and a lens module 42 (such as being composed of multiple optical lenses) carried by the lens holder 41. For example, the circuit substrate 1 has a plurality of conductive substrate pads 10P disposed on the upper surface 1001 of the circuit substrate 1, the image sensing chip 2 has a plurality of conductive chip pads 20P disposed on the upper surface 2001 of the image sensing chip 2, the image sensing chip 2 has an image sensing area 20S disposed on the upper surface 2001 and corresponding to the lens module 42, and the conductive chip pads 20P of the image sensing chip 2 can be electrically connected to the conductive substrate pads 10P of the circuit substrate 1 through a plurality of metal wires W (can be any conductive metal material such as gold, silver or copper), respectively. In addition, according to different requirements, the image sensing chip 2 can be a charge coupled device (CCD) or a complementary metal-oxide semiconductor (CMOS).

More particularly, referring to FIG. 1 and FIG. 2, the circuit substrate 1 has a flat surrounding structure 11 (only shown schematically in FIG. 2 and FIG. 4, but not shown in FIG. 1 and FIG. 3) adjacent to and surrounding the through opening 1003. In addition, the lower surface 2002 of the image sensing chip 2 is not covered by the insulating connection structure 3 and can be exposed outside, and the lower surface 1110 of the flat surrounding structure 11 can be substantially (or completely) flush with the lower surface 2002 of the image sensing chip 2. For example, the circuit substrate 1 may include a circuit layout layer 101 (such as the copper layout layer) disposed on the lower surface 1002 of the circuit substrate 1 and an insulating covering layer 102 (such as a solder mask or a solder resist) for covering the circuit layout layer 101, and the circuit layout layer 101 may have a plurality of conductive track portions 1010 (or conductive line portions) adjacent to the through opening 1003 and surrounding the through opening 1003. Moreover, the insulating covering layer 102 may include a plurality of first covering portions 102A, a plurality of second covering portions 102B, and a plurality of recessed spaces 102C, the first covering portions 102A can be disposed on the lower surface 1002 of the circuit substrate 1, the second covering portions 102B (each second covering portion 102B may be in a stepped or concave shape) can be configured to respectively cover the conductive track portions 1010, and each of the recessed spaces 102C can be located between a corresponding one of the first covering portions 102A and two adjacent ones of the second covering portions 102B. In addition, the flat surrounding structure 11 of the circuit substrate 1 may include a plurality of filling material layers 111 (such as a conductive material that does not electrically connect to the circuit layout layer 101, or a non-conductive material that is the same as or different from the material of the insulating covering layer 102), and the filling material layers 111 of the flat surrounding structure 11 can be respectively filled (completely filled) in the recessed spaces 102C of the insulating covering layer 102.

It should be noted that, for example, referring to FIG. 1 and FIG. 2, a lower surface 1110 of each filling material layer 111 of the flat surrounding structure 11 and a lower surface 1020 of each second covering portion 102B of the insulating covering layer 102 can be substantially (or completely) flush with each other, and the lower surface 1110 of each filling material layer 111 of the flat surrounding structure 11 and the lower surface 2002 of the image sensing chip 2 can be substantially (or completely) flush with each other. Therefore, when a temporary carrier substrate C (such as a soft tape or any kind of carrier) is flatly attached to the lower surface 1110 of each filling material layer 111 of the flat surrounding structure 11 and the lower surface 1020 of each second covering portion 102B of the insulating covering layer 102 (as shown in FIG. 1, at this time, the lower surface 2002 of the image sensing chip 2 is also flatly attached to the temporary carrier substrate C through the adhesive material), during the process of the insulating connection structure 3 being filled in the through opening 1003 of the circuit substrate 1, the insulating connection structure 3 will only be filled in the through opening 1003 of the circuit substrate 1 and will not overflow between the temporary carrier substrate C and the bottom surface 1110 of each filling material layer 111 of the flat surrounding structure 11, or between the temporary carrier substrate C and the lower surface 1020 of each second covering portion 102B of the insulating covering layer 102 (That is to say, there is not any gap between the temporary carrier substrate C and the lower surface 1110 of each filling material layer 111 of the flat surrounding structure 11, and there is not any gap between the temporary carrier substrate C and the lower surface 1020 of each second covering portion 102B of the insulating covering layer 102), thereby avoiding the occurrence of glue overflow (overfill) or residual glue on the bottom (or back) of the circuit substrate 1 of the image capturing module M (or preventing glue overflow or glue residue from forming on the bottom of the circuit substrate 1 of the image capturing module M).

Therefore, referring to FIG. 3 and FIG. 4, after the temporary carrier substrate C is separated from the circuit substrate 1 through direct irradiation of laser light generated by a laser generator or indirect heating by a heat source generated by a heater, the insulating connection structure 3 has a lower surrounding surface 3000 that is exposed outside and not covered, and the lower surrounding surface 3000 of the insulating connection structure 3, the lower surface (i.e., the lower surface 1110 of each filling material layer 111 and the lower surface 1020 of each second covering portion 102B of the insulating covering layer 102) of the flat surrounding structure 11 and the lower surface 2002 of the image sensing chip 2 can be substantially (or completely) flush with each other. For example, when the temporary carrier substrate C is separated from the circuit substrate 1 through direct irradiation of laser light generated by a laser generator or indirect heating by a heat source generated by a heater, the lower surrounding surface 3000 of the insulating connection structure 3 will generate a resin deformation mark (or a resin deformation trace, not shown in figures) formed after the insulating connection structure 3 is heated by a heat source generated by a laser generator or a heater.

For example, as shown in FIG. 1 or FIG. 3, in one of the feasible embodiments, the thickness of the insulating connection structure 3 can be less than or equal to the thickness of the image sensing chip 2, the thickness of the insulating connection structure 3 can be less than or equal to the thickness of the circuit substrate 1, and the insulating connection structure 3 can be tightly connected between an outer surrounding surface 2000 of the image sensing chip 2 and an inner surrounding surface 1004 of the through opening 1003 of the circuit substrate 1. Moreover, in one of the feasible embodiments, the inner surrounding surface 1004 of the through opening 1003 of the circuit substrate 1 can be configured as a surrounding roughened surface, thereby increasing a bonding force or a contact area between the insulating connection structure 3 and the circuit substrate 1. In addition, in one of the feasible embodiments, all or a part of the outer surrounding surface 2000 of the image sensing chip 2 can be covered by the insulating connection structure 3, thereby adjusting a bonding strength or a contact area between the insulating connection structure 3 and the image sensing chip 2 (that is to say, when the area of the outer surrounding surface 2000 of the image sensing chip 2 covered by the insulating connection structure 3 becomes larger, the bonding force or the contact area between the insulating connection structure 3 and the image sensing chip 2 will also become larger).

For example, in one of the feasible embodiments, the insulating connection structure 3 has an extended connection portion (or an extending connecting portion, not shown in figures) extending to the upper surface 1001 of the circuit substrate 1, thereby increasing the bonding force or the contact area between the insulating connection structure 3 and the circuit substrate 1. That is to say, the insulating connection structure 3 can overlap the upper surface 1001 of the circuit substrate 1 through the extension of the extended connection portion, so that the contact area between the insulating connection structure 3 and the circuit substrate 1 can be increased (or the insulating connection structure 3 can get more support from the circuit substrate 1), thereby making the insulating connection structure 3 not easily separated from the through opening 1003 of the circuit substrate 1 due to an external force (such as an external force applied for removing the temporary carrier substrate C from the circuit substrate 1, as shown in FIG. 4).

It should be noted that, for example, as shown in FIG. 1 or FIG 3, the image capturing module M provided by the first embodiment of the present invention further includes a filter element 5 that can be disposed and supported above the image sensing chip 2 by a plurality of support bodies (not labeled) or a surrounding support member (not labeled), the filter element 5 can be surrounded by the metal wires W, and the height of the filter element 5 relative to the image sensing chip 2 can be higher or lower than the height of each metal wire W relative to the image sensing chip 2.

### [Second Embodiment]

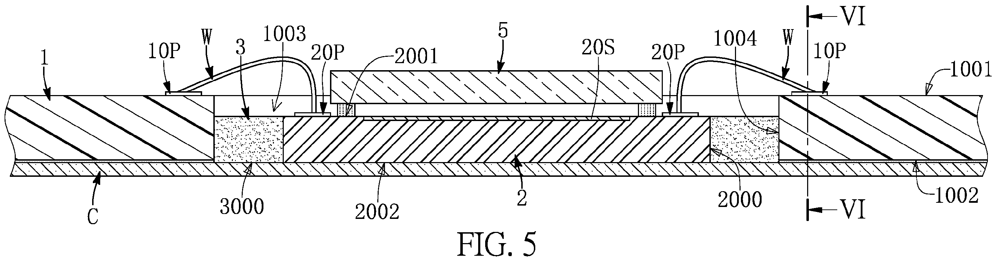

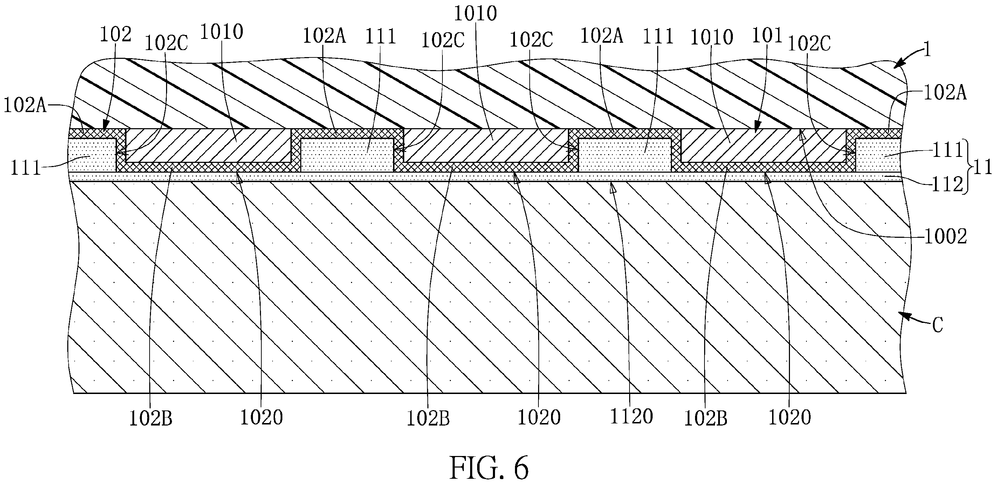

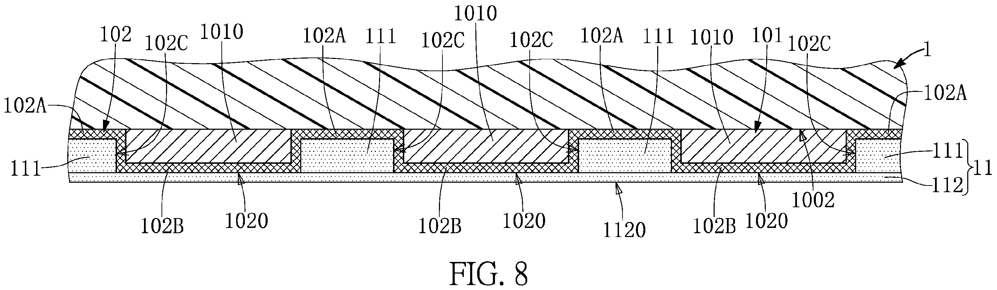

Referring to FIG. 5 to FIG. 8, a second embodiment of the present invention provides an image capturing module M. Comparing FIG. 6 with FIG. 2, and comparing FIG. 8 with FIG. 4, the main difference between the second embodiment and the first embodiment is as follows: in the second embodiment, the flat surrounding structure 11 of the circuit substrate 1 may include a plurality of filling material layers 111 and a thickening material layer 112 (or a material thickening layer), the filling material layers 111 (such as a conductive material that does not electrically connect to the circuit layout layer 101, or a non-conductive material that is the same as or different from the material of the insulating covering layer 102) of the flat surrounding structure 11 can be respectively filled (or completely filled) in the recessed spaces 102C of the insulating covering layer 102, and the thickening material layer 112 can be configured to cover the filling material layers 111 and the second covering portions 102B. It should be noted that the thickening material layer 112 of the flat surrounding structure 11 has a flat surface 1120, and the flat surface 1120 of the thickening material layer 112 of the flat surrounding structure 11 and the lower surface 2002 of the image sensing chip 2 can be substantially (or completely) flush with each other. Therefore, when a temporary carrier substrate C (such as a soft tape or any kind of carrier) is flatly attached to the flat surface 1120 of the thickening material layer 112 of the flat surrounding structure 11 (as shown in FIG. 5, at this time, the lower surface 2002 of the image sensing chip 2 is also flatly attached to the temporary carrier substrate C through the adhesive material), during the process of the insulating connection structure 3 being filled in the through opening 1003 of the circuit substrate 1, the insulating connection structure 3 will only be filled in the through opening 1003 of the circuit substrate 1 and will not overflow between the temporary carrier substrate C and the flat surface 1120 of the thickening material layer 112 of the flat surrounding structure 11 (That is to say, there is not any gap between the temporary carrier substrate C and the flat surface 1120 of the thickening material layer 112 of the flat surrounding structure 11), thereby avoiding the occurrence of glue overflow (overfill) or residual glue on the bottom (or back) of the circuit substrate 1 of the image capturing module M (or preventing glue overflow or glue residue from forming on the bottom of the circuit substrate 1 of the image capturing module M).

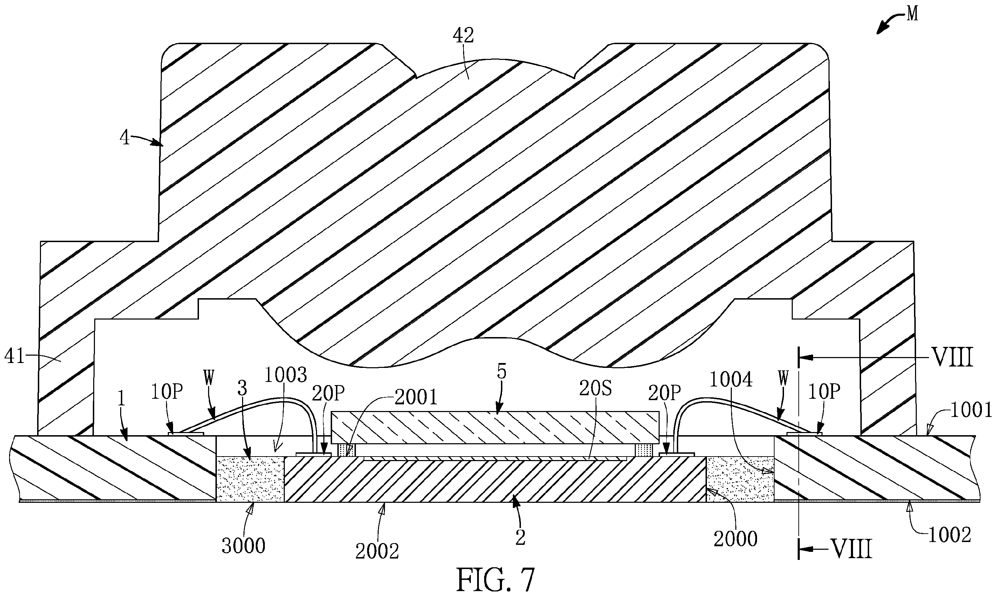

Therefore, referring to FIG. 7 and FIG. 8, after the temporary carrier substrate C is separated from the circuit substrate 1 through direct irradiation of laser light generated by a laser generator or indirect heating by a heat source generated by a heater, the insulating connection structure 3 has a lower surrounding surface 3000 that is exposed outside and not covered, and the lower surrounding surface 3000 of the insulating connection structure 3, the lower surface (i.e., the flat surface 1120 of the thickening material layer 112 of the flat surrounding structure 11) of the flat surrounding structure 11 and the lower surface 2002 of the image sensing chip 2 can be substantially (or completely) flush with each other. For example, when the temporary carrier substrate C is separated from the circuit substrate 1 through direct irradiation of laser light generated by a laser generator or indirect heating by a heat source generated by a heater, the lower surrounding surface 3000 of the insulating connection structure 3 will generate a resin deformation mark (or a resin deformation trace, not shown in figures) formed after the insulating connection structure 3 is heated by a heat source generated by a laser generator or a heater.

### [Third Embodiment]

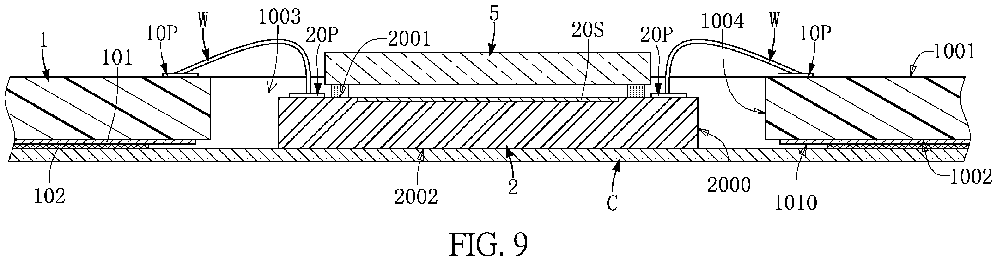

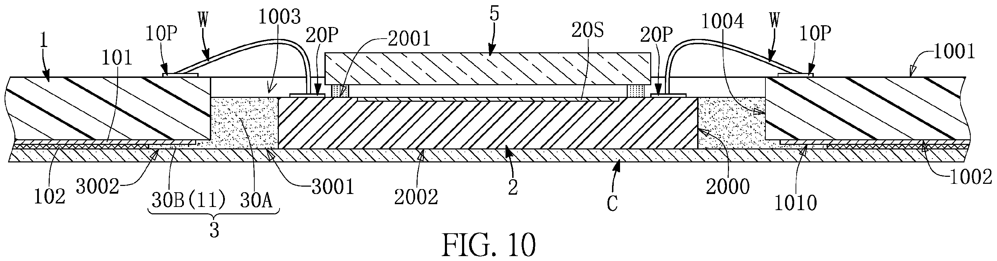

Referring to FIG. 9 and FIG. 10, a third embodiment of the present invention provides an image capturing module M. The main difference between the third embodiment and the first and second embodiments is as follows: in the third embodiment, the insulating connection structure 3 may include a main filling layer 30A (or a first surrounding filling layer) disposed in the through opening 1003 of the circuit substrate 1 and a surrounding filling layer 30B (or a second surrounding filling layer which has a maximum width that can be any positive integer between 100 µm and 150 µm) surroundingly connected (integrally connected or non-integrally connected) to the main filling layer 30A, the surrounding filling layer 30B can be configured to serve as the flat surrounding structure 11, and the surrounding filling layer 30B can be disposed on the lower surface 1002 of the circuit substrate 1 to cover the conductive track portions 1010 of the circuit layout layer 101. Therefore, when a temporary carrier substrate C (such as a soft tape or any kind of carrier) is flatly attached to the bottom surface of the circuit substrate 1 (at this time, the lower surface 2002 of the image sensing chip 2 is also flatly attached to the temporary carrier substrate C through the adhesive material), during the process of the insulating connection structure 3 being filled in the through opening 1003 of the circuit substrate 1, the insulating connection structure 3 will only be filled in the through opening 1003 of the circuit substrate 1 and will not overflow between the temporary carrier substrate C and the insulating covering layer 102 (That is to say, there is not any gap between the temporary carrier substrate C and the insulating covering layer 102), thereby avoiding the occurrence of glue overflow (overfill) or residual glue on the bottom (or back) of the circuit substrate 1 of the image capturing module M (or preventing glue overflow or glue residue from forming on the bottom of the circuit substrate 1 of the image capturing module M).

Therefore, referring to FIG. 10, after the temporary carrier substrate C is separated from the circuit substrate 1 through direct irradiation of laser light generated by a laser generator or indirect heating by a heat source generated by a heater, a lower surface 3001 of the main filling layer 30A, a lower surface 3002 of the surrounding filling layer 30B serving as the flat surrounding structure 11, and the lower surface 2002 of the image sensing chip 2 can be substantially (or completely) flush with each other. For example, when the temporary carrier substrate C is separated from the circuit substrate 1 through direct irradiation of laser light generated by a laser generator or indirect heating by a heat source generated by a heater, the lower surrounding surface 3000 (the lower surface 3001 of the main filling layer 30A and the lower surface 3002 of the surrounding filling layer 30B) of the insulating connection structure 3 will generate a resin deformation mark (or a resin deformation trace, not shown in figures) formed after the insulating connection structure 3 is heated by a heat source generated by a laser generator or a heater.

### [Fourth Embodiment]

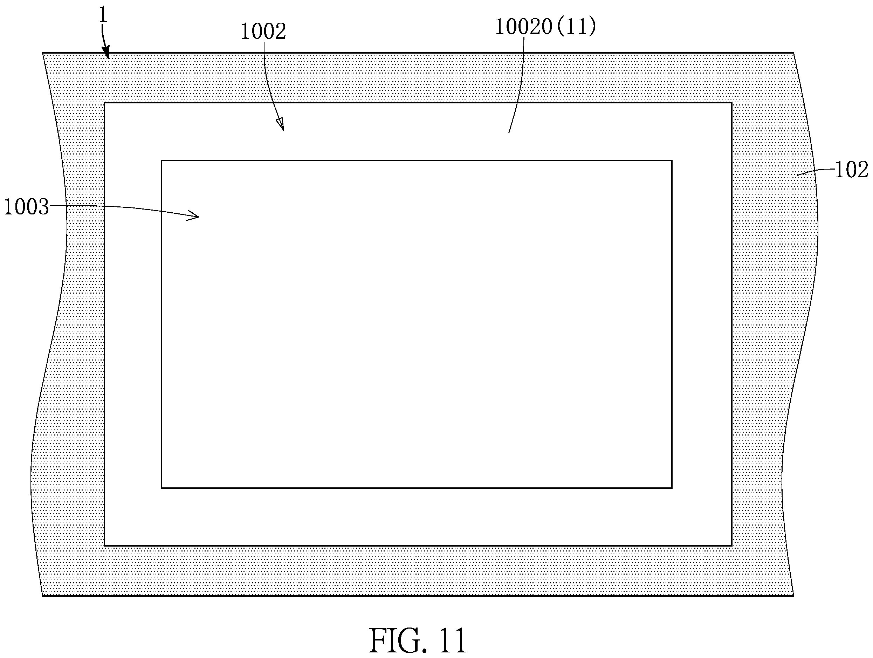

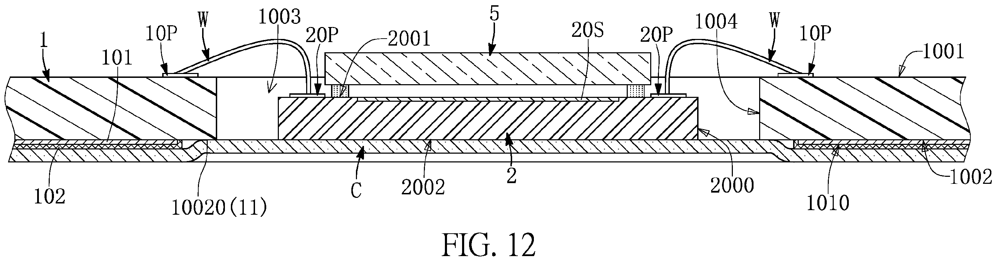

Referring to FIG. 11 to FIG. 13, a fourth embodiment of the present invention provides an image capturing module M. The main difference between the fourth embodiment and the first, second and third embodiments is as follows: in the fourth embodiment, the lower surface 1002 of the circuit substrate 1 may have a non-circuit layout area 10020 (or a substrate clearance area or a substrate unoccupied area which has a maximum width that can be any positive integer between 100 µm and 150 µm), the non-circuit layout area 10020 of the circuit substrate 1 can be surrounded by the circuit layout layer 101 and the insulating covering layer 102, and the non-circuit layout area 10020 of the circuit substrate 1 can be configured to serve as the flat surrounding structure 11. Therefore, when a temporary carrier substrate C (such as a soft tape or any kind of carrier) is flatly attached to the bottom surface of the circuit substrate 1 (at this time, the lower surface 2002 of the image sensing chip 2 is also flatly attached to the temporary carrier substrate C through the adhesive material), during the process of the insulating connection structure 3 being filled in the through opening 1003 of the circuit substrate 1, the insulating connection structure 3 will only be filled in the through opening 1003 of the circuit substrate 1 and will not overflow between the temporary carrier substrate C and the non-circuit layout area 10020 of the circuit substrate 1 (That is to say, there is not any gap between the temporary carrier substrate C and the non-circuit layout area 10020 of the circuit substrate 1), thereby avoiding the occurrence of glue overflow (overfill) or residual glue on the bottom (or back) of the circuit substrate 1 of the image capturing module M (or preventing glue overflow or glue residue from forming on the bottom of the circuit substrate 1 of the image capturing module M).

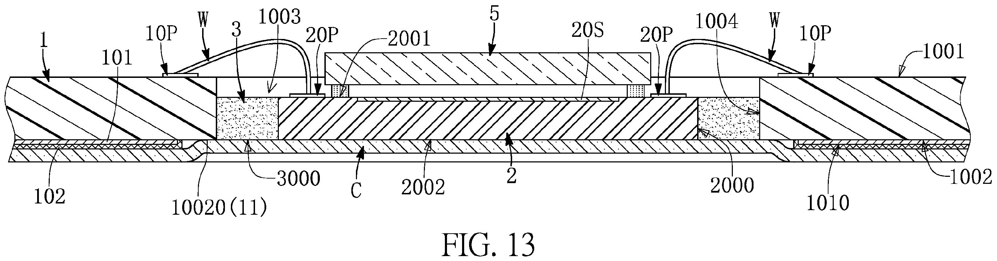

Therefore, referring to FIG. 13, after the temporary carrier substrate C is separated from the circuit substrate 1 through direct irradiation of laser light generated by a laser generator or indirect heating by a heat source generated by a heater, the insulating connection structure 3 has a lower surrounding surface 3000 that is exposed outside and not covered, and the lower surrounding surface 3000 of the insulating connection structure 3, the non-circuit layout area 10020 of the circuit substrate 1 and the lower surface 2002 of the image sensing chip 2 can be substantially (or completely) flush with each other. For example, when the temporary carrier substrate C is separated from the circuit substrate 1 through direct irradiation of laser light generated by a laser generator or indirect heating by a heat source generated by a heater, the lower surrounding surface 3000 of the insulating connection structure 3 will generate a resin deformation mark (or a resin deformation trace, not shown in figures) formed after the insulating connection structure 3 is heated by a heat source generated by a laser generator or a heater.

### [Fifth Embodiment]

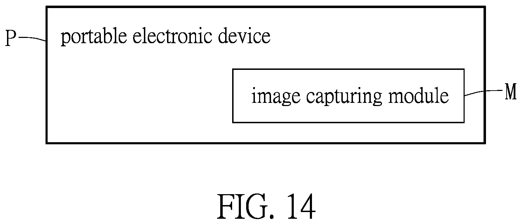

Referring to FIG. 14, a fifth embodiment of the present invention provides a portable electronic device P. The portable electronic device P can be configured to use any image capturing module M provided in the first, second, third and fourth embodiments. For example, the portable electronic device P can be a smartphone, a desktop computer, a notebook computer, a tablet computer or any kind of electronic device.

It should be noted that, for example, in the first to fifth embodiments of the present invention, the present invention can further provide a method for manufacturing an image capturing module M, which may include: firstly, making a circuit substrate 1 and a temporary carrier substrate C be allowed to be close to each other so as to place the circuit substrate 1 on the temporary carrier substrate C (or until the circuit substrate 1 and the temporary carrier substrate C are completely in contact with each other), in which a bottom side of the through opening 1003 of the circuit substrate 1 is closed or covered by the temporary carrier substrate C; next, placing an image sensing chip 2 in the through opening 1003 of the circuit substrate 1 and on the temporary carrier substrate C, and then forming an insulating connection structure 3 in the through opening 1003 of the circuit substrate 1 and between the image sensing chip 2 and the circuit substrate 1; then, removing the temporary carrier substrate C from the circuit substrate 1; afterward, electrically connecting the image sensing chip 2 to the circuit substrate 1 through a plurality of metal wires W; next, placing a lens assembly 4 on the circuit substrate 1, in which the lens assembly 4 includes a lens holder 41 disposed on the circuit substrate 1 and a lens module 42 carried or held by the lens holder 41. More particularly, according to different processing requirements, the temporary carrier substrate C can be removed from the circuit substrate 1 after the step of forming the insulating connection structure 3 in the through opening 1003 of the circuit substrate 1, the temporary carrier substrate C can be removed from the circuit substrate 1 after the step of electrically connecting the image sensing chip 2 to the circuit substrate 1 through a plurality of metal wires W, or the temporary carrier substrate C can be removed from the circuit substrate 1 after the step of placing the lens assembly 4 on the circuit substrate 1.

It should be noted that, for example, in the first to fifth embodiments of the present invention, the present invention can further provide a method for manufacturing an image capturing module M, which may include: firstly, making a circuit substrate 1 and a temporary carrying substrate C be allowed to be close to each other so as to place the circuit substrate 1 on the temporary carrying substrate C (or until the circuit substrate 1 and the temporary carrying substrate C are completely in contact with each other), in which a bottom side of the through opening 1003 of the circuit substrate 1 is closed or covered by the temporary carrying substrate C; next, placing an image sensing chip 2 in the through opening 1003 of the circuit substrate 1 and on the temporary carrying substrate C through an adhesive layer (such as double-sided tape or any kind of adhesive layer); then, electrically connecting the image sensing chip 2 to the circuit substrate 1 through a plurality of metal wires W (or placing a filter element 5 above the image sensing chip 2 through a plurality of support bodies or a surrounding support member); afterward, forming an insulating connection structure 3 in the through opening 1003 of the circuit substrate 1 and between the image sensing chip 2 and the circuit substrate 1; next, removing the temporary carrying substrate C from the circuit substrate 1; then, placing a lens assembly 4 on the circuit substrate 1, in which the lens assembly 4 includes a lens holder 41 disposed on the circuit substrate 1 and a lens module 42 carried or held by the lens holder 41. It should be noted that according to different processing requirements, the wire bonding step (or a chip electrical connection step) of electrically connecting the image sensing chip 2 to the circuit substrate 1 through the metal wires W and the glue filling step (or a chip position-limiting step) of forming the insulating connection structure 3 in the through opening 1003 of the circuit substrate 1 and between the image sensing chip 2 and the circuit substrate 1 can be performed or executed in sequence (sequentially) or in reverse (reversely), so that the glue filling step can be performed first and then the wire bonding step can be performed next, or the wire bonding step can be performed first and then the glue filling step can be performed next.

### [Beneficial Effects of the Embodiments]

In conclusion, in the image capturing module M and the portable electronic device P provided by the present invention, by virtue of "the image sensing chip 2 being disposed in the through opening 1003 of the circuit substrate 1 and electrically connected to the circuit substrate 1," "the insulating connection structure 3 being disposed in the through opening 1003 of the circuit substrate 1 and connected between the image sensing chip 2 and the circuit substrate 1," "a lower surface 2002 of the image sensing chip 2 being not covered by the insulating connection structure 3 and being exposed outside" and "the circuit substrate 1 having a flat surrounding structure 11 adjacent to and surrounding the through opening 1003," a lower surface 1002 of the flat surrounding structure 11 can be substantially (or completely) flush with the lower surface 2002 of the image sensing chip 2.

Therefore, during the process of the insulating connection structure 3 being filled in the through opening 1003 of the circuit substrate 1, the insulating connection structure 3 will not overflow between the temporary carrier substrate C and the flat surrounding structure 11, thereby avoiding the occurrence of glue overflow (overfill) or residual glue on the bottom (or back) of the circuit substrate 1 of the image capturing module M (or preventing glue overflow or glue residue from forming on the bottom of the circuit substrate 1 of the image capturing module M).

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

## Claims

1. An image capturing module (M), **characterized by** comprising:
a circuit substrate (1) having an upper surface (1001), a lower surface (1002), and a through opening (1003) connected between the upper surface (1001) and the lower surface (1002);
an image sensing chip (2) disposed in the through opening (1003) of the circuit substrate (1) and electrically connected to the circuit substrate (1); and
an insulating connection structure (3) disposed in the through opening (1003) of the circuit substrate (1) and connected between the image sensing chip (2) and the circuit substrate (1);
wherein a lower surface (2002) of the image sensing chip (2) is not covered by the insulating connection structure (3) and is exposed outside; and
wherein the circuit substrate (1) has a flat surrounding structure (11) adjacent to and surrounding the through opening (1003), and a lower surface (1110) of the flat surrounding structure (11) is flush with the lower surface (2002) of the image sensing chip (2).

2. The image capturing module (M) according to claim 1,
wherein the circuit substrate (1) includes a circuit layout layer (101) disposed on the lower surface (1002) of the circuit substrate (1) and an insulating covering layer (102) for covering the circuit layout layer (101), and the circuit layout layer (101) has a plurality of conductive track portions (1010) adjacent to and surrounding the through opening (1003);
wherein the insulating covering layer (102) includes a plurality of first covering portions (102A), a plurality of second covering portions (102B), and a plurality of recessed spaces (102C), the plurality of first covering portions (102A) are disposed on the lower surface (1002) of the circuit substrate (1), the plurality of second covering portions (102B) are configured to respectively cover the plurality of conductive track portions (1010), and each of the plurality of recessed spaces (102C) is located between a corresponding one of the plurality of first covering portions (102A) and two adjacent ones of the plurality of second covering portions (102B);
wherein the flat surrounding structure (11) of the circuit substrate (1) includes a plurality of filling material layers (111), and the plurality of filling material layers (111) of the flat surrounding structure (11) are respectively filled in the plurality of recessed spaces (102C) of the insulating covering layer (102);
wherein a lower surface (1110) of each of the plurality of filling material layers (111) of the flat surrounding structure (11) and a lower surface (1020) of each of the plurality of second covering portions (102B) of the insulating covering layer (102) are flush with each other, and the lower surface (1110) of each of the plurality of filling material layers (111) of the flat surrounding structure (11) and the lower surface (2002) of the image sensing chip (2) are flush with each other; and
wherein the insulating connection structure (3) has a lower surrounding surface (3000) that is exposed outside and not covered, and the lower surrounding surface (3000) of the insulating connection structure (3), the lower surface (1110) of the flat surrounding structure (11) and the lower surface (2002) of the image sensing chip (2) are flush with each other.

3. The image capturing module (M) according to claim 1,
wherein the circuit substrate (1) includes a circuit layout layer (101) disposed on the lower surface (1002) of the circuit substrate (1) and an insulating covering layer (102) for covering the circuit layout layer (101), and the circuit layout layer (101) has a plurality of conductive track portions (1010) adjacent to and surrounding the through opening (1003);
wherein the insulating covering layer (102) includes a plurality of first covering portions (102A), a plurality of second covering portions (102B), and a plurality of recessed spaces (102C), the plurality of first covering portions (102A) are disposed on the lower surface (1002) of the circuit substrate (1), the plurality of second covering portions (102B) are configured to respectively cover the plurality of conductive track portions (1010), and each of the plurality of recessed spaces (102C) is located between a corresponding one of the plurality of first covering portions (102A) and two adjacent ones of the plurality of second covering portions (102B);
wherein the flat surrounding structure (11) of the circuit substrate (1) includes a plurality of filling material layers (111) and a thickening material layer (112), the plurality of filling material layers (111) of the flat surrounding structure (11) are respectively filled in the plurality of recessed spaces (102C) of the insulating covering layer (102), and the thickening material layer (112) is configured to cover the plurality of filling material layers (111) and the plurality of second covering portions (102B);
wherein the thickening material layer (112) of the flat surrounding structure (11) has a flat surface (1120), and the flat surface (1120) of the thickening material layer (112) of the flat surrounding structure (11) and the lower surface (2002) of the image sensing chip (2) are flush with each other; and
wherein the insulating connection structure (3) has a lower surrounding surface (3000) that is exposed outside and not covered, and the lower surrounding surface (3000) of the insulating connection structure (3), the lower surface (1110) of the flat surrounding structure (11) and the lower surface (2002) of the image sensing chip (2) are flush with each other.

4. The image capturing module (M) according to claim 1,
wherein the circuit substrate (1) includes a circuit layout layer (101) disposed on the lower surface (1002) of the circuit substrate (1) and an insulating covering layer (102) for covering the circuit layout layer (101), and the circuit layout layer (101) has a plurality of conductive track portions (1010) adjacent to and surrounding the through opening (1003);
wherein the insulating connection structure (3) includes a main filling layer (30A) disposed in the through opening (1003) of the circuit substrate (1) and a surrounding filling layer (30B) surroundingly connected to the main filling layer (30A), the surrounding filling layer (30B) is configured to be the flat surrounding structure (11), and the surrounding filling layer (30B) is disposed on the lower surface (1002) of the circuit substrate (1) to cover the plurality of conductive track portions (1010) of the circuit layout layer (101); and
wherein, a lower surface (3001) of the main filling layer (30A), a lower surface (3002) of the surrounding filling layer (30B) serving as the flat surrounding structure (11), and the lower surface (2002) of the image sensing chip (2) are flush with each other.

5. The image capturing module (M) according to claim 1,
wherein the circuit substrate (1) includes a circuit layout layer (101) disposed on the lower surface (1002) of the circuit substrate (1) and an insulating covering layer (102) for covering the circuit layout layer (101), and the circuit layout layer (101) has a plurality of conductive track portions (1010) adjacent to and surrounding the through opening (1003);
wherein the lower surface (1002) of the circuit substrate (1) has a non-circuit layout area (10020), the non-circuit layout area (10020) of the circuit substrate (1) is surrounded by the circuit layout layer (101) and the insulating covering layer (102), and the non-circuit layout area (10020) of the circuit substrate (1) is configured to serve as the flat surrounding structure (11);
wherein a maximum width of the non-circuit layout area (10020) of the circuit substrate (1) is between 100 µm and 150 µm;
wherein the insulating connection structure (3) has a lower surrounding surface (3000) that is exposed outside and not covered, and the lower surrounding surface (3000) of the insulating connection structure (3), the non-circuit layout area (10020) of the circuit substrate (1) and the lower surface (2002) of the image sensing chip (2) are flush with each other;
wherein the circuit substrate (1) has a plurality of conductive substrate pads (10P) disposed on the upper surface (1001) thereof, the image sensing chip (2) has a plurality of conductive chip pads (20P) disposed on the upper surface (2001) thereof, and the plurality of conductive chip pads (20P) of the plurality of image sensing chip (2) are electrically connected to the plurality of conductive substrate pads (10P) of the circuit substrate (1) through a plurality of metal wires (W), respectively;
wherein the insulating connection structure (3) is tightly connected between an outer surrounding surface (2000) of the image sensing chip (2) and an inner surrounding surface (1004) of the through opening (1003) of the circuit substrate (1);
wherein the inner surrounding surface (1004) of the through opening (1003) of the circuit substrate (1) is configured as a surrounding roughened surface, thereby increasing a bonding force or a contact area between the insulating connection structure (3) and the circuit substrate (1);
wherein, all or a part of the outer surrounding surface (2000) of the image sensing chip (2) is covered by the insulating connection structure (3), thereby adjusting a bonding strength or a contact area between the insulating connection structure (3) and the image sensing chip (2);
wherein a thickness of the insulating connection structure (3) is less than or equal to a thickness of the image sensing chip (2) and less than or equal to a thickness of the circuit substrate (1);
wherein the image capturing module (M) further comprises a lens assembly (4) that includes a lens holder (41) disposed on the circuit substrate (1) and a lens module (42) carried by the lens holder (41), and the image sensing chip (2) has an image sensing area (20S) disposed on an upper surface (2001) thereof and corresponding to the lens module (42); and
wherein the image capturing module (M) further comprises a filter element (5) disposed and supported above the image sensing chip (2) by a plurality of support bodies or a surrounding support member, and the filter element (5) is surrounded by the metal wires (W).

6. A portable electronic device (P) configured to use an image capturing module (M), **characterized in that** the image capturing module (M) includes:
a circuit substrate (1) having an upper surface (1001), a lower surface (1002), and a through opening (1003) connected between the upper surface (1001) and the lower surface (1002);
an image sensing chip (2) disposed in the through opening (1003) of the circuit substrate (1) and electrically connected to the circuit substrate (1); and
an insulating connection structure (3) disposed in the through opening (1003) of the circuit substrate (1) and connected between the image sensing chip (2) and the circuit substrate (1);
wherein a lower surface (2002) of the image sensing chip (2) is not covered by the insulating connection structure (3) and is exposed outside; and
wherein the circuit substrate (1) has a flat surrounding structure (11) adjacent to and surrounding the through opening (1003), and a lower surface (1110) of the flat surrounding structure (11) is flush with the lower surface (2002) of the image sensing chip (2).

7. The portable electronic device (P) according to claim 6,
wherein the circuit substrate (1) includes a circuit layout layer (101) disposed on the lower surface (1002) of the circuit substrate (1) and an insulating covering layer (102) for covering the circuit layout layer (101), and the circuit layout layer (101) has a plurality of conductive track portions (1010) adjacent to and surrounding the through opening (1003);
wherein the insulating covering layer (102) includes a plurality of first covering portions (102A), a plurality of second covering portions (102B), and a plurality of recessed spaces (102C), the plurality of first covering portions (102A) are disposed on the lower surface (1002) of the circuit substrate (1), the plurality of second covering portions (102B) are configured to respectively cover the plurality of conductive track portions (1010), and each of the plurality of recessed spaces (102C) is located between a corresponding one of the plurality of first covering portions (102A) and two adjacent ones of the plurality of second covering portions (102B);
wherein the flat surrounding structure (11) of the circuit substrate (1) includes a plurality of filling material layers (111), and the plurality of filling material layers (111) of the flat surrounding structure (11) are respectively filled in the plurality of recessed spaces (102C) of the insulating covering layer (102);
wherein a lower surface (1110) of each of the plurality of filling material layers (111) of the flat surrounding structure (11) and a lower surface (1020) of each of the plurality of second covering portions (102B) of the insulating covering layer (102) are flush with each other, and the lower surface (1110) of each of the plurality of filling material layers (111) of the flat surrounding structure (11) and the lower surface (2002) of the image sensing chip (2) are flush with each other; and
wherein the insulating connection structure (3) has a lower surrounding surface (3000) that is exposed outside and not covered, and the lower surrounding surface (3000) of the insulating connection structure (3), the lower surface (1110) of the flat surrounding structure (11) and the lower surface (2002) of the image sensing chip (2) are flush with each other.

8. The portable electronic device (P) according to claim 6,
wherein the circuit substrate (1) includes a circuit layout layer (101) disposed on the lower surface (1002) of the circuit substrate (1) and an insulating covering layer (102) for covering the circuit layout layer (101), and the circuit layout layer (101) has a plurality of conductive track portions (1010) adjacent to and surrounding the through opening (1003);
wherein the insulating covering layer (102) includes a plurality of first covering portions (102A), a plurality of second covering portions (102B), and a plurality of recessed spaces (102C), the plurality of first covering portions (102A) are disposed on the lower surface (1002) of the circuit substrate (1), the plurality of second covering portions (102B) are configured to respectively cover the plurality of conductive track portions (1010), and each of the plurality of recessed spaces (102C) is located between a corresponding one of the plurality of first covering portions (102A) and two adjacent ones of the plurality of second covering portions (102B);
wherein the flat surrounding structure (11) of the circuit substrate (1) includes a plurality of filling material layers (111) and a thickening material layer (112), the plurality of filling material layers (111) of the flat surrounding structure (11) are respectively filled in the plurality of recessed spaces (102C) of the insulating covering layer (102), and the thickening material layer (112) is configured to cover the plurality of filling material layers (111) and the plurality of second covering portions (102B);
wherein the thickening material layer (112) of the flat surrounding structure (11) has a flat surface (1120), and the flat surface (1120) of the thickening material layer (112) of the flat surrounding structure (11) and the lower surface (2002) of the image sensing chip (2) are flush with each other; and
wherein the insulating connection structure (3) has a lower surrounding surface (3000) that is exposed outside and not covered, and the lower surrounding surface (3000) of the insulating connection structure (3), the lower surface (1110) of the flat surrounding structure (11) and the lower surface (2002) of the image sensing chip (2) are flush with each other.

9. The portable electronic device (P) according to claim 6,
wherein the circuit substrate (1) includes a circuit layout layer (101) disposed on the lower surface (1002) of the circuit substrate (1) and an insulating covering layer (102) for covering the circuit layout layer (101), and the circuit layout layer (101) has a plurality of conductive track portions (1010) adjacent to and surrounding the through opening (1003);
wherein the insulating connection structure (3) includes a main filling layer (30A) disposed in the through opening (1003) of the circuit substrate (1) and a surrounding filling layer (30B) surroundingly connected to the main filling layer (30A), the surrounding filling layer (30B) is configured to be the flat surrounding structure (11), and the surrounding filling layer (30B) is disposed on the lower surface (1002) of the circuit substrate (1) to cover the plurality of conductive track portions (1010) of the circuit layout layer (101); and
wherein, a lower surface (3001) of the main filling layer (30A), a lower surface (3002) of the surrounding filling layer (30B) serving as the flat surrounding structure (11), and the lower surface (2002) of the image sensing chip (2) are flush with each other.

10. The portable electronic device (P) according to claim 6,
wherein the circuit substrate (1) includes a circuit layout layer (101) disposed on the lower surface (1002) of the circuit substrate (1) and an insulating covering layer (102) for covering the circuit layout layer (101), and the circuit layout layer (101) has a plurality of conductive track portions (1010) adjacent to and surrounding the through opening (1003);
wherein the lower surface (1002) of the circuit substrate (1) has a non-circuit layout area (10020), the non-circuit layout area (10020) of the circuit substrate (1) is surrounded by the circuit layout layer (101) and the insulating covering layer (102), and the non-circuit layout area (10020) of the circuit substrate (1) is configured to serve as the flat surrounding structure (11);
wherein a maximum width of the non-circuit layout area (10020) of the circuit substrate (1) is between 100 µm and 150 µm;
wherein the insulating connection structure (3) has a lower surrounding surface (3000) that is exposed outside and not covered, and the lower surrounding surface (3000) of the insulating connection structure (3), the non-circuit layout area (10020) of the circuit substrate (1) and the lower surface (2002) of the image sensing chip (2) are flush with each other;
wherein the circuit substrate (1) has a plurality of conductive substrate pads (10P) disposed on the upper surface (1001) thereof, the image sensing chip (2) has a plurality of conductive chip pads (20P) disposed on the upper surface (2001) thereof, and the plurality of conductive chip pads (20P) of the plurality of image sensing chip (2) are electrically connected to the plurality of conductive substrate pads (10P) of the circuit substrate (1) through a plurality of metal wires (W), respectively;
wherein the insulating connection structure (3) is tightly connected between an outer surrounding surface (2000) of the image sensing chip (2) and an inner surrounding surface (1004) of the through opening (1003) of the circuit substrate (1);
wherein the inner surrounding surface (1004) of the through opening (1003) of the circuit substrate (1) is configured as a surrounding roughened surface, thereby increasing a bonding force or a contact area between the insulating connection structure (3) and the circuit substrate (1);
wherein, all or a part of the outer surrounding surface (2000) of the image sensing chip (2) is covered by the insulating connection structure (3), thereby adjusting a bonding strength or a contact area between the insulating connection structure (3) and the image sensing chip (2);
wherein a thickness of the insulating connection structure (3) is less than or equal to a thickness of the image sensing chip (2) and less than or equal to a thickness of the circuit substrate (1);
wherein the image capturing module (M) further comprises a lens assembly (4) that includes a lens holder (41) disposed on the circuit substrate (1) and a lens module (42) carried by the lens holder (41), and the image sensing chip (2) has an image sensing area (20S) disposed on an upper surface (2001) thereof and corresponding to the lens module (42); and
wherein the image capturing module (M) further comprises a filter element (5) disposed and supported above the image sensing chip (2) by a plurality of support bodies or a surrounding support member, and the filter element (5) is surrounded by the metal wires (W).
